# EUROPEAN PATENT APPLICATION

(11) **EP 4 756 442 A1**
(43) Date of publication of application: **10.06.2026**
(21) Application number: 25220712.1
(22) Date of filing: 04.12.2025
(51) Int. Cl.: G01R 31/08, H04B 3/46

(54) **MONITORING APPARATUS, MONITORING METHOD, AND MONITORING PROGRAM**

(30) Priority: 09.12.2024 JP 2024214561
(71) Applicant: Yokogawa Electric Corporation, Musashino-shi, Tokyo 180-8750 (JP)
(72) Inventor: OGAWA, Hiromitsu, Musashino-shi, Tokyo, 180-8750 (JP); ASAWA, Satoshi, Musashino-shi, Tokyo, 180-8750 (JP); NAKATSU, Yuri, Musashino-shi, Tokyo, 180-8750 (JP); KONADA, Soichiro, Musashino-shi, Tokyo, 180-8750 (JP)
(74) Representative: Winter, Brandl - Partnerschaft mbB

(57) **Abstract**

An operator terminal (10) acquires measurement data representing a characteristic of an optical fiber in a cable (C) connecting plural wind turbines (W), the cable (C) including a power transmission line and the optical fiber, and monitors, on the basis of the measurement data and section information indicating plural cable sections corresponding to locations, the cable (C) for each of the plural cable sections, the locations each being a location where a state of the cable (C) is common.

## Description

### FIELD

The present disclosure relates to a monitoring apparatus, a monitoring method, and a monitoring program.

### BACKGROUND

Multi-core cables ("cables", as appropriate) are power transmission cables, which connect offshore wind turbines ("wind turbines", as appropriate) for offshore wind power generation ("wind power generation", as appropriate) and are buried under the seabed. Operators who manage wind power generation measure temperature at each point (for example, every meter) on multi-core cables and monitor states of the cables on the basis of changes in the temperature (see, for example, Japanese Laid-open Patent Publication No. 2016-201989).

However, improving precision of the monitoring of the cables with the above mentioned technique is difficult. For example, it is difficult to monitor a cable accurately with the technique because the amount of electric current flowing varies by location of the cable and different amounts of heat are thus generated at different points on the cable.

The present disclosure is made in view of the above and an object thereof is to improve precision of monitoring of a cable.

### SUMMARY

According to an aspect of the embodiments, a monitoring apparatus, includes a storage unit, and a processor connected to the storage unit, wherein the storage unit stores section information indicating plural sections each being a section where a state of a cable is common, the cable connecting plural facilities and including a power transmission line and an optical fiber, and the processor executes acquiring measurement data representing a characteristic of the optical fiber in the cable, and monitoring the cable for each of the plural sections on the basis of the measurement data and the section information.

According to an aspect of the embodiments,
A monitoring method, wherein a monitoring apparatus executes acquiring measurement data representing a characteristic of an optical fiber in a cable connecting plural facilities, the cable including a power transmission line and the optical fiber, and monitoring, on the basis of the measurement data and section information indicating plural sections each being a section where a state of the cable is common, whether or not an abnormality in the cable is present for each of the plural sections.

According to an aspect of the embodiments, a monitoring program that causes a monitoring apparatus to execute acquiring measurement data representing a characteristic of an optical fiber in a cable connecting plural facilities, the cable including a power transmission line and the optical fiber, and monitoring, on the basis of the measurement data and section information indicating plural sections each being a section where a state of the cable is common, whether or not an abnormality in the cable is present for each of the plural sections.

### BRIEF DESCRIPTION OF THE DRAWINGS

FIG. 1 is a diagram illustrating an example of a configuration of and an example of processes in a cable monitoring system according to an embodiment;
FIG. 2 is a block diagram illustrating an example of a configuration of each apparatus in the cable monitoring system according to the embodiment;
FIG. 3 is a diagram illustrating an example of a measurement data storage unit of an operator terminal, according to the embodiment;
FIG. 4 is a diagram illustrating an example of a section information storage unit of the operator terminal, according to the embodiment;
FIG. 5 is a diagram illustrating an example of a correction data storage unit of the operator terminal, according to the embodiment;
FIG. 6 is a diagram illustrating an example of a monitoring result storage unit of the operator terminal, according to the embodiment;
FIG. 7 is a diagram illustrating a specific example of a section setting process in the cable monitoring system according to the embodiment;
FIG. 8 is a diagram illustrating a first specific example of a data correction process in the cable monitoring system according to the embodiment;
FIG. 9 is a diagram illustrating a second specific example of the data correction process in the cable monitoring system according to the embodiment;
FIG. 10 is a diagram illustrating a third specific example of the data correction process in the cable monitoring system according to the embodiment;
FIG. 11 is a diagram illustrating a specific example of a cable monitoring process in the cable monitoring system according to the embodiment;
FIG. 12 is a flowchart illustrating an example of an overall flow in the cable monitoring system according to the embodiment;
FIG. 13 is a flowchart illustrating an example of a flow of a setting management process in the cable monitoring system according to the embodiment;
FIG. 14 is a flowchart illustrating an example of a flow of a measurement management process in the cable monitoring system according to the embodiment;
FIG. 15 is a flowchart illustrating an example of a flow of a correction management process in the cable monitoring system according to the embodiment;
FIG. 16 is a flowchart illustrating an example of a flow of a monitoring management process in the cable monitoring system according to the embodiment; and
FIG. 17 is a diagram illustrating an example of a hardware configuration according to the embodiment.

### DETAILED DESCRIPTION OF THE PREFERRED EMBODIMENTS

A monitoring apparatus, a monitoring method, and a monitoring program, according to one embodiment of the present disclosure will hereinafter be described in detail by reference to the drawings. The present disclosure is not to be limited by the embodiment described hereinafter.

A configuration of and processes in a cable monitoring system 100 according to the embodiment, a configuration of and processes in each apparatus of the cable monitoring system 100, flows of the processes in the cable monitoring system 100, and effects of the embodiment will be described hereinafter.

### 1. Configuration of and Processes in Cable Monitoring System 100

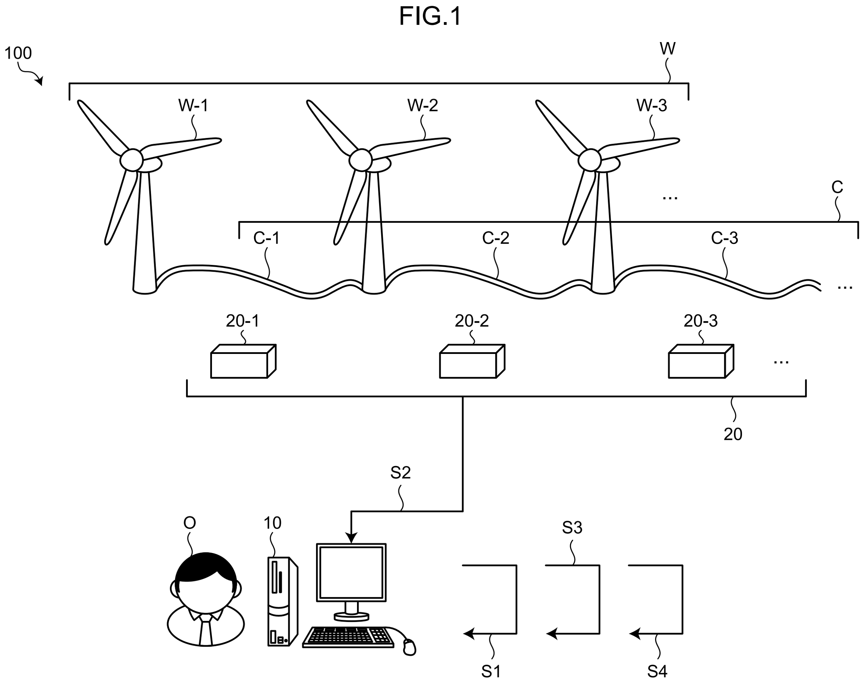

The configuration of and the processes in the cable monitoring system 100 according to the embodiment will be described by use of FIG. 1. FIG. 1 is a diagram illustrating an example of the configuration of and an example of the processes in the cable monitoring system 100 according to the embodiment. An example of an overall configuration of the cable monitoring system 100, the example of the processes in the cable monitoring system 100, and effects of the cable monitoring system 100 will be described hereinafter.

An example where undersea cables for offshore wind power generation are monitored will be described with respect to the embodiment, but use purposes and application fields are not to be particularly limited to this example. Furthermore, "monitoring" may include "diagnosing" for checking whether or not any abnormality is present in a target in a given time period.

### 1-1. Example of Overall Configuration of Cable Monitoring System 100

The following description is on the example of the overall configuration of the cable monitoring system 100. The cable monitoring system 100 includes an operator terminal 10, measurement apparatuses 20, wind turbines W, and cables C. The operator terminal 10 is communicably connected by wire or wirelessly via a predetermined communication network not illustrated in the drawings. Any of various communication networks, such as the Internet and dedicated lines, may be adopted as the predetermined communication network.

### 1-1-1. Operator Terminal 10

The operator terminal 10 is a manager terminal used by an operator O who is a manager of wind power generation facilities. For example, the operator terminal 10 is installed in a ship, an offshore facility, or an onshore facility (for example, an electrical substation or a monitoring center) and is operated by the operator O. The cable monitoring system 100 illustrated in FIG. 1 may include a plurality of the operator terminals 10. In the example of FIG. 1, the operator terminal 10 is implemented by a desktop personal computer (PC) but the operator terminal 10 may be implemented by, for example, a notebook PC, a smartphone, a server apparatus, or a cloud system.

### 1-1-2. Measurement Apparatus 20

The measurement apparatuses 20 (20-1, 20-2, 20-3, ...) are apparatuses that measure measurement data M representing characteristics of optical fibers F included in the cables C. For example, the measurement apparatuses 20 are connected to the optical fibers F included in the cables C and measure, as the measurement data M, temperatures (°C) of the optical fibers F and attenuations (dB) of light through the optical fibers F. The characteristics of the optical fibers F represent states of the cables C, in which the optical fibers F have been provided, and these characteristics represent overall characteristics, such as chemical properties, physical properties, and optical properties, of the optical fibers F, without being limited to the above mentioned temperatures (°C) and attenuations (dB) of light.

### 1-1-3. Wind Turbine W

The wind turbines W (W-1, W-2, W-3, ...) are wind power generation facilities that generate power using wind power. In the example of FIG. 1, the wind turbines W are installed on the sea in the order, a wind turbine W-1, a wind turbine W-2, a wind turbine W-3, ..., from an offshore point on the sea to an onshore point and each generate electricity A.

### 1-1-4. Cable C

The cables C (C-1, C-2, C-3, ...) are power transmission cables that are multi-core cables each including a power transmission line L and the optical fiber F and that connect the wind turbines W and an electrical substation. In the example of FIG. 1, the cables C, the cable C-1 connecting the wind turbine W-1 and the wind turbine W-2, the cable C-2 connecting the wind turbine W-2 and the wind turbine W-3, the cable C-3 connecting the wind-turbine W-3 and so on, ... are buried under the seabed in this order and transmit the electricity A generated, to the electrical substation (not illustrated in the drawings) that is onshore.

### 1-2. Example of Overall Process in Cable Monitoring System 100

The following description is on an example of an overall process in the cable monitoring system 100. Processes at Steps S1 to S4 described below may be executed in a different order. Furthermore, some of the processes at Steps S1 to S4 described below may be omitted.

### 1-2-1. Cable Section Setting Process

Firstly, the operator terminal 10 sets a cable section CS (Step S1). For example, the operator terminal 10 sets a cable section CS where a state of a cable C is common. A cable section CS represents a location of a cable C, the location being a location where a state of the cable C (for example, the amount of electric current flowing through its power transmission line L, the heat radiation state of the cable C, or the installation state of the cable C) is common. Furthermore, a location of a cable C is at least any one section of the cable C that is a single continuous cable C or plural connected cables C and the location of the cable C includes plural points P corresponding to points of measurement by the measurement apparatuses 20. Furthermore, a cable section CS of a cable C is a single or plural sections of the cable C automatically or manually set on the basis of a state of the cable C.

By using, as measurement data M-P acquired in the past, temperatures T-P of the optical fibers F and attenuations AR-P of light through the optical fibers F, the operator terminal 10 sets a cable section CS corresponding to a location where the amount of electric current through, the heat radiation state of, or the installation state of the cable or cables C is common. Furthermore, the operator terminal 10 sets a cable section CS for each of the plural cables C (C-1, C-2, C-3, ...) connecting the plural wind turbines W (W-1, W-2, W-3, ...). Furthermore, the operator terminal 10 sets a cable section CS for each of plural locations of a cable C. Furthermore, the operator terminal 10 sets a cable section CS for each location in a region around a wind turbine W and a region other than the region around the wind turbine W.

### 1-2-2. Measurement Data Acquisition Process

Secondly, the operator terminal 10 acquires measurement data M (Step S2). For example, the operator terminal 10 acquires measurement data M-1 representing a characteristic of the cable C-1 measured by the measurement apparatus 20-1, measurement data M-2 representing a characteristic of the cable C-2 measured by the measurement apparatus 20-2, measurement data M-3 representing a characteristic of the cable C-3 measured by the measurement apparatus 20-3, and so on. The measurement data M acquired by the operator terminal 10 are, for example, temperatures T of the optical fibers F and attenuations AR of light through the optical fibers F.

The measurement apparatuses 20 are capable of measuring plural points P on the cables C. For example, the measurement apparatuses 20 are capable of measuring the measurement data M-1 representing the characteristic of the cable C-1 and the measurement data M-2 representing the characteristic of the cable C-2.

### 1-2-3. Measurement Data Correction Process

Thirdly, the operator terminal 10 corrects the measurement data M for each cable section CS (Step S3). For example, the operator terminal 10 normalizes the past measurement data M-P measured at each point P in a cable section CS by a variation coefficient, and calculates a correction parameter CP on the basis of a numerical value resulting from this normalization. Subsequently, the operator terminal 10 finds a deviation value for the measurement data M-P on the basis of the correction parameter CP and calculates corrected measurement data M-DC. The deviation value represents a numerical value representing deviation from a predetermined value and is, for example, a numerical value representing deviation from a correction parameter CP, but is not particularly limited. The operator terminal 10 may normalize present measurement data M for each point P by a variation coefficient and reflect a numerical value resulting from this normalization in the correction parameter CP.

The operator terminal 10 may execute statistical processing in the above described measurement correction process and identify any abnormality, that is, any singularity, in the cables C. Examples of the statistical processing include calculating the standard deviation, variance, mean, variation coefficient, weighted average, intermediate value, or median, other statistical methods (generating a histogram), and any combination of these but the statistical processing is not particularly limited. Furthermore, the operator terminal 10 may calculate an approximate curve (regression curve) for distance of a cable C by using temperature T of the optical fiber F and attenuation AR of light through the optical fiber F and identify any singularity on the basis of the approximate curve calculated. For singularity calculation, a singularity is identified by calculating a deviation value from a standard value calculated from the above mentioned statistical processing or approximate curve. Examples of a process of calculating the deviation value is subtraction processing but the process is not particularly limited.

### 1-2-4. Cable Monitoring Process

Fourthly, the operator terminal 10 monitors the cables C (Step S4). For example, in a case where corrected measurement data M-DC exceed an upper limit threshold X, the operator terminal 10 detects an abnormality in the cables C. Furthermore, in a case where corrected measurement data M-DC are less than a lower limit threshold Y, the operator terminal 10 detects an abnormality in the cables C.

In this detection, the operator terminal 10 may notify the operator O of an alarm. For example, in a case where corrected measurement data M-DC exceed the upper limit threshold X or corrected measurement data M-DC are less than the lower limit threshold Y, the operator terminal 10 notifies the operator O of detection of an abnormality in the cables C by generating an alarm sound. Furthermore, the operator terminal 10 may execute linear prediction using past measurement data M-P or corrected measurement data M-DC or prediction by machine learning, and perform notification of a degree of future risk with an alarm or a warning.

### 1-3. Effects of Cable Monitoring System 100

Effects of the cable monitoring system 100 will be described hereinafter, after a description of an outline of and a problem in a cable monitoring system 100-P according to a reference technique.

### 1-3-1. Outline of Cable Monitoring System 100-P

In the cable monitoring system 100-P, an operator O measures a temperature T at each point P (for example, every meter) on a cable C and monitors the cable C on the basis of changes in temperature. When the cable C is damaged, the cable C increases in electrical resistance and generates heat. Furthermore, when the cable C is exposed to the sea from its buried position underground beneath the seabed, the cable C is cooled by seawater. That is, in the cable monitoring system 100-P, the operator O monitors the cable C on the basis of temperature changes like those mentioned above.

### 1-3-2. Problem in Cable Monitoring System 100-P

In the cable monitoring system 100-P, the operator O evaluates temperature changes at respective points P on the cable C when monitoring the cable C but because the amount of electric current flowing varies by location of the cable C in practice, accurate monitoring of the cable C is difficult.

For example, in a case where the cable C is connected to wind turbines W in a daisy chain, the amount of electric current flowing varies by location of the cable C. Specifically, in a case where the cable C is connected to a wind turbine W-1, a wind turbine W-2, a wind turbine W-3, and an electrical substation in this order from an offshore point on the sea to an onshore point, electricity A-1 generated by the wind turbine W-1 flows between the wind turbine W-1 and the wind turbine W-2, and electricity A-2 generated by the wind-turbine W-1 and the wind turbine W-2 flows between the wind-turbine W-2 and the wind turbine W-3. Therefore, the amount of electric current flowing in the cable C varies by location. Therefore, in the cable monitoring system 100-P, the amount of heat generated varies by location of the cable C and it is thus difficult for the operator O to consistently evaluate temperature changes in the cable C.

As described above, the cable monitoring system 100-P has a problem that precision of monitoring of the cable C is difficult to be improved.

### 1-3-3. Outline of Cable Monitoring System 100

In the cable monitoring system 100, the following process is executed. Firstly, the operator terminal 10 defines each section of the cable C as a cable section CS correspondingly to a state. Secondly, on the basis of measurement data M on characteristics of the cables C measured by the measurement apparatuses 20, the characteristics being, for example, temperatures T of the optical fibers F or attenuations AR of light through the optical fibers F, the operator terminal 10 corrects the measurement data M for each cable section CS defined. Thirdly, on the basis of the measurement data M on the temperatures T of the optical fibers F or the attenuations AR of light through the optical fibers F and the corrected measurement data M-DC, the operator terminal 10 monitors the cable sections CS.

### 1-3-4. Effects of Cable Monitoring System 100

The cable monitoring system 100 has the following effects. Firstly, the cable monitoring system 100 enables improvement in precision of evaluation of a state of a cable C by defining a cable section CS corresponding to a location where a state of the cable C is common. Secondly, by correcting the measurement data M for each cable section CS that has been defined, the cable monitoring system 100 enables improvement in precision of evaluation of the state of the cable C for each cable section CS. Thirdly, by automatically setting the cable section CS using the past measurement data M-P, the cable monitoring system 100 facilitates defining of the cable section CS and enables improvement in precision of evaluation of the state of the cable C.

Therefore, the cable monitoring system 100 enables improvement in precision of monitoring of the cable C.

### 2. Configuration of and Processes in Each Apparatus of Cable Monitoring System 100

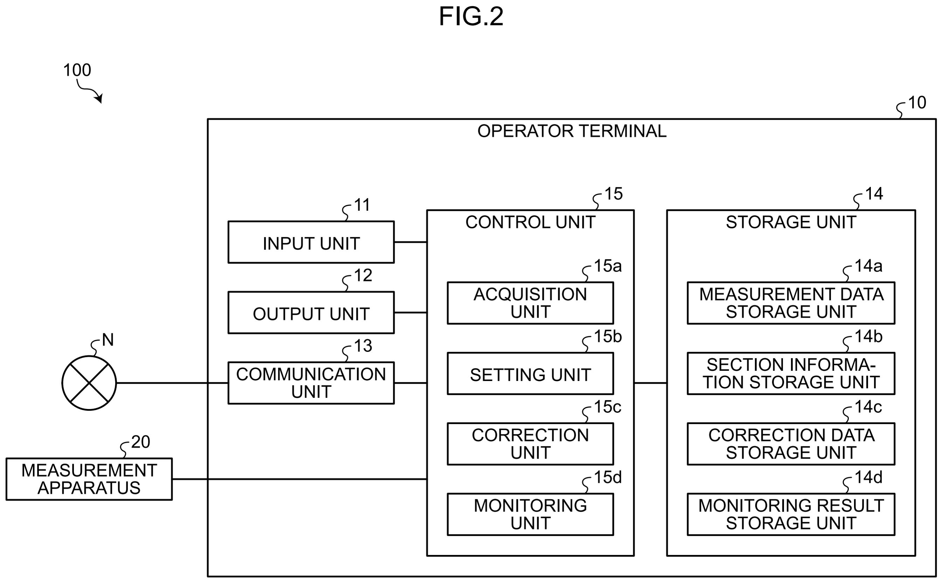

A configuration of and processes in each apparatus that the cable monitoring system 100 illustrated in FIG. 1 has will be described by use of FIG. 2. FIG. 2 is a block diagram illustrating an example of a configuration of each apparatus in the cable monitoring system 100 according to the embodiment. An example of an overall configuration of the cable monitoring system 100 according to the embodiment, an example of a configuration of and an example of processes at the operator terminal 10, and an example of a configuration of and an example of processes at a measurement apparatus 20 will be described hereinafter.

### 2-1. Example of Overall Configuration of Cable Monitoring System 100

The example of the overall configuration of the cable monitoring system 100 illustrated in FIG. 1 will be described by use of FIG. 2. As illustrated in FIG. 2, the cable monitoring system 100 includes the operator terminal 10 and a measurement apparatus 20. The operator terminal 10 is communicably connected by a communication network N implemented by the Internet or a dedicated line. The operator terminal 10 and the measurement apparatus 20 may be configured to be integrated with each other.

### 2-2. Example of Configuration of and Example of Processes at Operator Terminal 10

The example of the configuration of and the example of the processes at the operator terminal 10 will be described by use of FIG. 2. The operator terminal 10 has an input unit 11, an output unit 12, a communication unit 13, a storage unit 14, and a control unit 15.

### 2-2-1. Input Unit 11

The input unit 11 governs input of various kinds of information to the operator terminal 10. For example, the input unit 11 is implemented by a mouse, a keyboard, and/or a touch panel, and receives input of various kinds of information to the operator terminal 10.

### 2-2-2. Output Unit 12

The output unit 12 governs output of various kinds of information from the operator terminal 10. For example, the output unit 12 is implemented by a display and a speaker, and outputs various kinds of information stored in the operator terminal 10.

### 2-2-3. Communication Unit 13

The communication unit 13 governs data communication with another apparatus. For example, via a router, the communication unit 13 performs data communication with each communication device. The communication unit 13 is also capable of performing data communication with a terminal not illustrated in the drawings.

### 2-2-4. Storage Unit 14

The storage unit 14 stores various kinds of information referred to when the control unit 15 operates and various kinds of information acquired when the control unit 15 operates. The storage unit 14 includes a measurement data storage unit 14a, a section information storage unit 14b, a correction data storage unit 14c, and a monitoring result storage unit 14d. For example, the storage unit 14 stores: section information I set for each location including each point P on two or more cables C, each point P being a point where a characteristic is within a predetermined range; section information I set for each of plural locations including each point P on one cable C, each point P being a point where a characteristic is within a predetermined range; or section information I set for each location including each point in a region around a facility that two or more cables C are connected to and in a region other than the region around the facility. The storage unit 14 may be implemented by a semiconductor memory element, such as a random access memory (RAM) or a flash memory, or a storage device, such as a hard disk or an optical disk. In the example of FIG. 2, the storage unit 14 is installed in the operator terminal 10 but the storage unit 14 may be installed outside the operator terminal 10 or plural storage units may be installed.

### 2-2-4-1. Measurement Data Storage Unit 14a

The measurement data storage unit 14a stores measurement data M. For example, the measurement data storage unit 14a stores measurement data M acquired by an acquisition unit 15a of the control unit 15 described later. The measurement data M may be on temperature T of an optical fiber F. Furthermore, the measurement data M may be on attenuation AR of light through an optical fiber F.

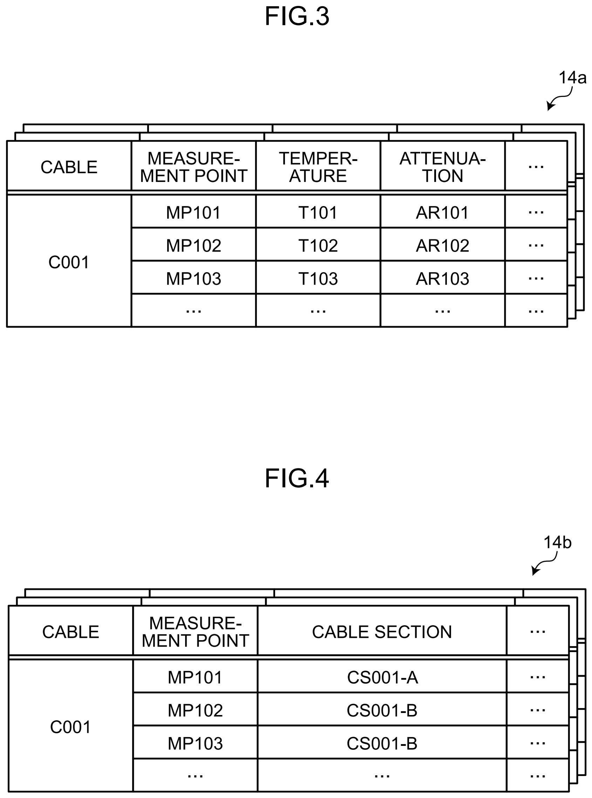

An example of data stored in the measurement data storage unit 14a will be described by use of FIG. 3. FIG. 3 is a diagram illustrating an example of the measurement data storage unit 14a in the operator terminal 10 according to the embodiment. In the example of FIG. 3, the measurement data storage unit 14a has items, such as "Cable", "Measurement point", "Temperature", and "Attenuation".

"Cable" indicates identification information for identifying a cable C to be monitored, and is, for example, an identification number or identification symbol of a multi-core cable, which is an undersea cable connecting wind turbines W of offshore wind power generation facilities. "Measurement point" indicates measured points P on the cable C to be monitored, is, for example, points P at one meter intervals of the cable C, and is expressed by distances (m) from a predetermined starting point on the cable C. "Temperature" indicates history information on measured temperatures T of the cable C to be monitored, and is, for example, time-series data on temperatures (°C) of its optical fiber F. "Attenuation" indicates history information on measured attenuations AR of light through the cable C to be monitored, and is, for example, time-series data on attenuations (dB) of light through the optical fiber F.

That is, FIG. 3 illustrates an example where the measurement data storage unit 14a stores, for the cable C-1 identified by "C001", measurement data M illustrated as {Measurement point: "MP101", Temperature: "T101", Attenuation: "AR101"}, {Measurement point: "MP102", Temperature: "T102", Attenuation: "AR102"}, {Measurement point: "MP103", Temperature: "T103", Attenuation: "AR103"}, ....

### 2-2-4-2. Section Information Storage Unit 14b

The section information storage unit 14b stores section information I. For example, the section information storage unit 14b stores section information I on plural cable sections CS set by a setting unit 15b of the control unit 15 described later. Furthermore, the section information storage unit 14b stores section information I on plural cable sections CS input by the operator O via the input unit 11. Furthermore, the section information storage unit 14b stores section information I representing plural cable sections CS corresponding to locations, each location being where a state of the cable C is common, the cable C connecting plural facilities and including a power transmission line L and an optical fiber F. Furthermore, the section information storage unit 14b stores section information I representing plural cable sections CS set for each of plural cables C connecting plural facilities. Furthermore, the section information storage unit 14b stores section information I representing plural cable sections CS set for each of plural locations of a cable C. Furthermore, the section information storage unit 14b stores section information I representing plural cable sections CS set for each location in a region around a facility where plural cables C are connected to and in a region other than the region around the facility. The plural facilities are, for example, plural power transmission facilities. Furthermore, the plural facilities are, for example, offshore wind power generation facilities including plural wind turbines.

An example of data stored in the section information storage unit 14b will be described by use of FIG. 4. FIG. 4 is a diagram illustrating an example of the section information storage unit 14b in the operator terminal 10 according to the embodiment. In the example of FIG. 4, the section information storage unit 14b has items, such as "Cable, "Measurement point", and "Cable section".

"Cable" indicates identification information for identifying a cable C to be monitored, and is, for example, an identification number or identification symbol of a multi-core cable, which is an undersea cable connecting wind turbines W of offshore wind power generation facilities. "Measurement point" indicates measured points P on the cable C to be monitored, is, for example, points P at one meter intervals of the cable C, and is expressed by distances (m) from a predetermined starting point on the cable C. "Cable section" indicates plural sections corresponding to locations each being a location where a state of the cable C to be monitored is common, and is, for example: cable sections CS set correspondingly to locations each being a location where the amount of electric current through, the heat radiation state of, or the installation state of the cable C is common; cable sections CS set for each of plural cables C (C-1, C-2, C-3, ...) connecting plural wind turbines W (W-1, W-2, W-3, ...); cable sections CS set for each of plural locations of the cable C; or cable sections CS set for each location in a region around a wind turbine W and in a region other than the region around the wind turbine W.

That is, FIG. 4 illustrates an example where the section information storage unit 14b stores, for the cable C-1 identified by "C001", section information I illustrated as {Measurement point: "MP101", Cable section: "CS001-A"}, {Measurement point: "MP102", Cable section: "CS001-B"}, {Measurement point: "MP103", Cable section: "CS001-B"}, ....

### 2-2-4-3. Correction data storage unit 14c

The correction data storage unit 14c stores correction parameters CP and corrected measurement data M-DC. For example, the correction data storage unit 14c stores correction parameters CP including temperature correction parameters TP and attenuation correction parameters ARP, which have been calculated by a correction unit 15c of the control unit 15 described later. Furthermore, the correction data storage unit 14c stores corrected measurement data M-DC including corrected temperatures T-C and corrected attenuations AR-DC, which have been calculated by the correction unit 15c of the control unit 15 described later.

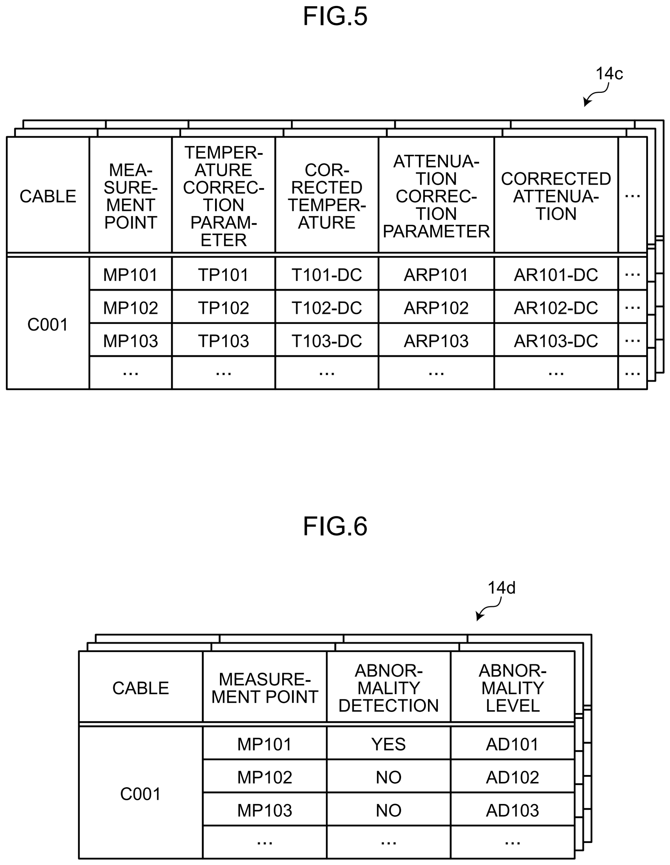

An example of data stored in the correction data storage unit 14c will be described by use of FIG. 5. FIG. 5 is a diagram illustrating an example of the correction data storage unit 14c in the operator terminal 10 according to the embodiment. In the example of FIG. 5, the correction data storage unit 14c has items, such as "Cable", "Measurement point", "Temperature correction parameter", "Corrected temperature", "Attenuation correction parameter", and "Corrected attenuation".

"Cable" indicates identification information for identifying a cable C to be monitored, and is, for example, an identification number or an identification symbol of a multi-core cable, which is an undersea cable connecting wind turbines W of offshore wind power generation facilities. "Measurement point" indicates measured points P on the cable C to be monitored, is, for example, points P at one meter intervals of the cable C, and is expressed by distances (m) from a predetermined starting point on the cable C. "Temperature correction parameter" indicates parameters for correcting temperatures T measured at the points P on the cable C to be monitored and is, for example, temperature parameters (°C) each calculated on the basis of temperatures T-P acquired in the past for correcting a temporal change in temperature T at the point P. "Corrected temperature" indicates corrected temperatures T-DC resulting from correction of the temperatures T of the cable C to be monitored, and is, for example, corrected temperatures (°C) of the optical fiber F. "Attenuation correction parameter" indicates parameters for correcting attenuations AR of light measured at the points P on the cable C to be monitored, and is, for example, attenuation parameters (dB) each calculated on the basis of attenuations AR-P of light acquired in the past for correcting a temporal change in attenuation AR of light at the point P. "Corrected attenuation" indicates corrected attenuations AR-DC resulting from correction of the attenuations AR of light through the cable C to be monitored and is, for example, corrected attenuations (dB) of light through the optical fiber F.

That is, FIG. 5 illustrates an example where the correction data storage unit 14c stores, for the cable C-1 identified by "C001", the correction parameters CP and the corrected measurement data M-DC illustrated as: {Measurement point: "MP101", Temperature correction parameter: "TP101", Corrected temperature: "T101-DC", Attenuation correction parameter: "ARP101", Corrected attenuation: "AR101-DC"}, {Measurement point: "MP102", Temperature correction parameter: "TP102", Corrected temperature: "T102-DC", Attenuation correction parameter: "ARP102", Corrected attenuation: "AR102-DC"}, {Measurement point: "MP103", Temperature correction parameter: "TP103", Corrected temperature: "T103-DC", Attenuation correction parameter: "ARP103", Corrected attenuation: "AR103-DC"}, ....

### 2-2-4-4. Monitoring Result Storage Unit 14d

The monitoring result storage unit 14d stores monitoring results D. For example, the monitoring result storage unit 14d stores monitoring results D on whether or not any abnormality is present in the cable C monitored by a monitoring unit 15d of the control unit described later.

An example of data stored in the monitoring result storage unit 14d will be described by use of FIG. 6. FIG. 6 is a diagram illustrating an example of the monitoring result storage unit 14d in the operator terminal 10 according to the embodiment. In the example of FIG. 6, the monitoring result storage unit 14d has items, such as "Cable", "Measurement point", "Abnormality detection", and "Abnormality level".

"Cable" indicates identification information for identifying a cable C to be monitored, and is, for example, an identification number or an identification symbol of a multi-core cable, which is an undersea cable connecting wind turbines W of offshore wind power generation facilities. "Measurement point" indicates measured points P on the cable C to be monitored, is, for example, points P at one meter intervals of the cable C, and is expressed by distances (m) from a predetermined starting point on the cable C. "Abnormality detection" indicates whether or not any abnormality detected at the points P on the cable C to be monitored is present and is, for example, expressed by "Yes" for any point P where an abnormality has been detected and by "No" for any point P where no abnormality has been detected. "Abnormality level" indicates numerical values, by which corrected measurement data M-DC deviate from an abnormality threshold representing an abnormality, and is expressed as, for example, "20°C", which is a numerical value by which a corrected temperature T-DC deviates from an abnormality threshold, or as "5 dB", which is a numerical value, by which a corrected attenuation AR-DC deviates from an abnormality threshold, but is not particularly limited.

That is, FIG. 6 illustrates an example where the monitoring result storage unit 14d stores, for the cable C-1 identified by "C001 ", monitoring results D illustrated as {Measurement point: "MP101 ", Abnormality detection: "Yes", Abnormality level: "AD101"}, {Measurement point: "MP102", Abnormality detection: "No", Abnormality level: "AD102"}, "{Measurement point: "MP103", Abnormality detection: "No", Abnormality level: "AD103"}, ....

### 2-2-5. Control Unit 15

The control unit 15 governs overall control of the operator terminal 10. The control unit 15 includes the acquisition unit 15a, the setting unit 15b, the correction unit 15c, and the monitoring unit 15d. The control unit 15 may be implemented by, for example, an electronic circuit, such as a central processing unit (CPU) or a microprocessing unit (MPU), or an integrated circuit, such as an application specific integrated circuit (ASIC) or a field programmable gate array (FPGA).

### 2-2-5-1. Acquisition Unit 15a

The acquisition unit 15a acquires various kinds of information. The acquisition unit 15a stores the various kinds of information acquired, into the storage unit 14. The following description is on a measurement data acquisition process (a temperature acquisition process and an attenuation acquisition process).

### Measurement Data Acquisition Process

The acquisition unit 15a executes the measurement data acquisition process. For example, the acquisition unit 15a acquires measurement data M representing characteristics of an optical fiber F in a cable C. Furthermore, the acquisition unit 15a acquires measurement data M measured by a measurement apparatus 20 connected to the optical fiber F. Furthermore, the acquisition unit 15a acquires measurement data M input by an operator O via the input unit 11. Furthermore, the acquisition unit 15a acquires measurement data M via the communication unit 13. The measurement data M acquired by the acquisition unit 15a may be measurement data M-P for a given time period in the past.

### Temperature Acquisition Process

The acquisition unit 15a executes the temperature acquisition process as the measurement data acquisition process. For example, the acquisition unit 15a acquires, as the measurement data M, temperatures T of the optical fiber F in the cable C. Furthermore, the acquisition unit 15a acquires, as the measurement data M, temperatures T measured by the measurement apparatus 20 connected to the optical fiber F.

The following description is on a specific example of the temperature acquisition process. Firstly, for the cable C-1 identified by "C001", the acquisition unit 15a acquires, as temperatures T measured by the measurement apparatus 20-1: {Measurement point: "MP101", Temperature: "T101"},{Measurement point: "MP102", Temperature: "T102"}, {Measurement point: "MP103", Temperature: "T103"}, .... Secondly, the acquisition unit 15a stores the acquires temperatures T in the measurement data storage unit 14a.

### Attenuation Acquisition Process

The acquisition unit 15a executes the attenuation acquisition process as the measurement data acquisition process. For example, the acquisition unit 15a acquires, as the measurement data M, attenuations AR of light through the optical fiber F in the cable C. Furthermore, the acquisition unit 15a acquires, as the measurement data M, attenuations AR of light measured by the measurement apparatus 20 connected to the optical fiber F.

The following description is on a specific example of the attenuation acquisition process. Firstly, for the cable C-1 identified by "C001", the acquisition unit 15a acquires, as attenuations AR of light measured by the measurement apparatus 20-1, {Measurement point: "MP101", Attenuation: "AR101"}, {Measurement point: "MP102", Attenuation: "AR102"}, {Measurement point: "MP103", Attenuation: "AR103"}, .... Secondly, the acquisition unit 15a stores the acquired attenuations AR of light into the measurement data storage unit 14a.

### 2-2-5-2. Setting Unit 15b

The setting unit 15b sets various kinds of information. The setting unit 15b may store the various kinds of information set, into the storage unit 14. Furthermore, the setting unit 15b may refer to the various kinds of information stored in the storage unit 14. The following description is on a cable section setting process (an electric current determination process, a heat radiation state determination process, and an installation state determination process).

### Cable Section Setting Process

The setting unit 15b executes the cable section setting process. For example, on the basis of measurement data M-P measured in the past, the setting unit 15b sets plural cable sections CS and stores the plural cable sections CS as section information I into the section information storage unit 14b. Furthermore, the setting unit 15b sets plural cable sections CS each being where a state is common, the state being the amount of electric current flowing through the power transmission line, the heat radiation state of the cable C, or the installation of the cable C. Furthermore, the setting unit 15b stores section information I input by an operator O who is a user, into the section information storage unit 14b.

The following description is on a specific example of the cable section setting process. Firstly, for the cable C-1 identified by "C001", the setting unit 15b refers to measurement data M stored in the measurement data storage unit 14a, the measurement data M being {Measurement point: "MP101", Temperature: "T101", Attenuation: "AR101"}, {Measurement point: "MP102", Temperature: "T102", Attenuation: "AR102"}, {Measurement point: "MP103", Temperature: "T103", Attenuation: "AR103"}, .... Secondly, the setting unit 15b refers to measurement data M-P for a given time period (for example: one day one week earlier, one day one month earlier, or one day one year earlier) in the past from measurement data M, the measurement data M-P being {Measurement point: "MP101", Temperature: "T101-P", Attenuation: "AR101-P"}, {Measurement point: "MP102", Temperature: "T102-P", Attenuation: "AR102-P"}, {Measurement point: "MP103", Temperature: "T103-P", Attenuation: "AR103-P"}, .... Thirdly, the setting unit 15b compares at least one of numerical values of the temperature T-P and numerical values of the attenuation AR-P of light, both of these numerical values being represented by the past measurement data M-P, among respective points P, and sets, as plural cable sections CS each corresponding to a location where a characteristic of the cable C is common, {Measurement point: "MP101 ", Cable section: "CS001-A"}, {Measurement point: "MP102", Cable section: "CS001-B"}, {Measurement point: "MP103", Cable section: "CS001-B"}, .... Fourthly, the setting unit 15b stores the plural cable sections CS that have been set, as section information I, into the section information storage unit 14b.

A location where a characteristic of the cable C is common refers to a section including points P where the past measurement data M-P represent numerical values in a predetermined range, and is, for example, a section including points P where: numerical values of the temperature T-P are in a predetermined range; numerical values of the attenuation AR-P of light are in a predetermined range; or numerical values of the temperature T-P are in a predetermined range and numerical values of the attenuation AR-P are in a predetermined range.

### Electric Current Determination Process

The setting unit 15b executes the electric current determination process as the cable section setting process. For example, the setting unit 15b sets plural cable sections CS each corresponding to a location where the amount of electric current flowing through the power transmission line L is common. In this process, for example, the setting unit 15b compares, as past measurement data M-P, temperatures T-P for one day one week earlier, and in a case where temperatures T-P in a given time period are in a predetermined range, the setting unit 15b determines that these temperatures T-P in the given time period correspond to a location where the amount of electric current flowing through the power transmission line L is common (for example, a cable C connecting the same wind turbines W). Furthermore, the setting unit 15b compares, as past measurement data M-P, attenuations AR-P of light for one day one week earlier, and in a case where attenuations AR-P of light in a given time period are in a predetermined range, the setting unit 15b determines that these attenuations AR-P of light in the given time period correspond a location where the amount of electric current flowing through the power transmission line L is common.

### Heat Radiation State Determination Process

The setting unit 15b executes the heat radiation determination process as the cable section setting process. For example, the setting unit 15b sets plural cable sections CS each corresponding to a location where the heat radiation state of the cable C is common. In this process, the setting unit 15b compares, as past measurement data M-P, for example, temperatures T-P for one day one month earlier, and in a case where temperatures T-P in a given time period are in a predetermined range, the setting unit 15b determines that these temperatures T-P in the given time period correspond to a location where the heat radiation state (for example, geological features at the buried position or the type of covering material) is common. Furthermore, the setting unit 15b compares, as past measurement data M-P, attenuations AR-P of light for one day one month earlier, and in a case where attenuations AR-P of light in a given time period are in a predetermined range, the setting unit 15b determines that these attenuations AR-P of light in the given time period correspond to a location where the heat radiation state is common.

### Installation State Determination Process

The setting unit 15b executes the installation state determination process as the cable section setting process. For example, the setting unit 15b sets plural cable sections CS each corresponding to a location where the installation state of the cable C is common. In this process, the setting unit 15b compares, as past measurement data M-P, for example, attenuations AR-P of light for one day one year earlier, and in a case where attenuations AR-P of light in a given time period are in a predetermined range, the setting unit 15b determines that these attenuations AR-P of light in the given time period correspond to a location where the installation state (for example, the depth of the buried position, exposure to the sea, or influence of the ocean current) is common. Furthermore, the setting unit 15b compares, as past measurement data M-P, temperatures T-P for one day one year earlier, and in a case where temperatures T-P in a given time period are in a predetermined range, the setting unit 15b determines that these temperatures T-P in the given time period correspond to a location where the installation state is common.

### 2-2-5-3. Correction Unit 15c

The correction unit 15c corrects various kinds of information. The correction unit 15c may store the various kinds of information that have been corrected, into the storage unit 14. Furthermore, the correction unit 15c may refer to the various kinds of information stored in the storage unit 14. The following description is on a measurement data correction process (a temperature correction process and an attenuation correction process).

### Measurement Data Correction Process

The correction unit 15c executes the measurement data correction process. For example, the correction unit 15c corrects measurement data M for each of plural cable sections CS. Furthermore, by using a correction parameter CP for each point P in the same cable section CS, the correction unit 15c corrects the measurement data M. Furthermore, by using measurement data M measured at each point P in the same cable section CS and correction parameters CP, the correction unit 15c calculates deviation values from the measurement data M measured at the respective points P and thereby corrects the measurement data M. Furthermore, by performing statistical processing of measurement data M measured at each point P in the same cable section CS, the correction unit 15c calculates correction parameters CP. A correction parameter CP is calculated by statistical processing of past measurement data M-P. Examples of the statistical processing include calculation of the standard deviation, variance, mean, variation coefficient, weighted average, intermediate value, and median, and other statistical methods (for example, generation of a histogram). Furthermore, by performing statistical processing of measurement data M-P measured in the past at each point P in the same cable section CS, the correction unit 15c calculates correction parameters CP. Furthermore, by statistical processing including at least average processing, the correction unit 15c calculates a correction parameter CP. The average processing is statistical processing for calculating an average, such as an arithmetic mean or a geometric mean. Furthermore, the correction unit 15c calculates a correction parameter CP by one or more kinds of statistical processing selected from a group including: calculation of the mean; calculation of the variance; and calculation of the variation coefficient. Furthermore, the correction unit 15c numerically expresses influence by the heat radiation state or the installation state, for example, using a correction parameter CP. Furthermore, by reflecting a correction parameter CP in measurement data M, the correction unit 15c calculates corrected measurement data M-DC. Furthermore, the correction unit 15c may calculate corrected measurement data M-DC by reflecting a numerical value attributable to an amount of electric current, in corrected measurement data M-DC, by statistical processing, for each point P in a cable section CS. Examples of the statistical processing include calculation of the standard deviation, variance, mean, variation coefficient, weighted average, intermediate value, and median, and other statistical methods (generation of a histogram). The statistical processing refers to a statistical technique for finding a distribution of individual elements in a group and consistently and quantitatively defining a trend or characteristic of the group.

### Temperature Correction Process

The correction unit 15c executes the temperature correction process as the measurement data correction process. For example, the correction unit 15c corrects temperatures T for each of plural cable sections CS. Furthermore, by using a temperature correction parameter TP for each point P in the same cable section CS, the correction unit 15c corrects temperatures T. By use of a temperature T measured at each point P in the same cable section CS and a temperature correction parameter TP, a deviation value is calculated from the temperature T measured at the point P and the temperature T is thereby corrected. Furthermore, by performing statistical processing of temperatures T measured at respective points P in the same cable section CS, the correction unit 15c calculates temperature correction parameters TP. The temperature correction parameters TP are calculated on the basis of temperatures T-P measured in the past, by the statistical processing, which may be any of: calculation of the standard deviation, variance, mean, variation coefficient, weighted average, intermediate value, and median, and other statistical methods (generation of a histogram). Furthermore, by performing statistical processing of temperatures T-P measured in the past at respective points P in the same cable section CS, the correction unit 15c calculates temperature correction parameters TP. Furthermore, by statistical processing including at least average processing, the correction unit 15c calculates a temperature correction parameter TP. Furthermore, the correction unit 15c calculates a temperature correction parameter TP by one or more kinds of statistical processing selected from a group including: calculation of the mean; calculation of the variance; and calculation of the variation coefficient. Furthermore, the correction unit 15c numerically expresses influence by the heat radiation state or the installation state, for example, using a temperature correction parameter TP. Furthermore, by reflecting a temperature correction parameter TP in a temperature T that has been measured, the correction unit 15c calculates a corrected temperature T-DC. Furthermore, the correction unit 15c may calculate, for each point P in a cable section CS, a numerical value attributable to an amount of electric current by statistical processing, which may be any of: calculation of the standard deviation, variance, mean, variation coefficient, weighted average, intermediate value, and median, and other statistical methods (generation of a histogram), reflect the numerical value attributable to the amount of electric current in a corrected temperature T-DC, and thereby calculate a corrected temperature T-DC.

The following description is on a specific example of the temperature correction process. Firstly, the correction unit 15c refers to, for the cable C-1 identified by "C001", section information I stored in the section information storage unit 14b, {Measurement point: "MP101", Cable section: "CS001-A"}, {Measurement point: "MP102", Cable section: "CS001-B"}, and {Measurement point: "MP103", Cable section: "CS001-B"}. Secondly, for the cable C-1 identified by "C001", the correction unit 15c refers to temperatures T stored in the measurement data storage unit 14a, {Measurement point: "MP102", Temperature: "T102"} and {Measurement point: "MP103", Temperature: "T103"} corresponding to the same cable section CS. Thirdly, the correction unit 15c calculates the mean value "TA102-103", which is the mean of temperatures "T102" and "T103" measured at measurement points "MP102" and "MP103". Fourthly, for the cable C-1 identified by "C001", the correction unit 15c refers to temperature correction parameters TP stored in the correction data storage unit 14c, {Measurement point: "MP102", Temperature correction parameter: "TP102"} and {Measurement point: "MP103", Temperature correction parameter: "TP103"}. Fifthly, the correction unit 15c calculates a variation coefficient by using the mean value "TA102-103" for the temperatures "T102" and "T103" measured at the measurement points "MP102" and "MP103", finds a deviation value from each of the temperature correction parameters "TP102" and "TP103", and thereby calculates corrected temperatures T-DC, {Measurement point: "MP102", Corrected temperature: "T102-DC"} and {Measurement point: "MP103", Corrected temperature: "T103-DC"}. Sixthly, the correction unit 15c stores the corrected temperatures T-DC calculated, into the correction data storage unit 14c.

### Attenuation Correction Process

The correction unit 15c executes the attenuation correction process as the measurement data correction process. For example, the correction unit 15c corrects attenuations AR of light for each of plural cable sections CS. Furthermore, by using an attenuation correction parameter ARP for each point P in the same cable section CS, the correction unit 15c corrects attenuations AR. By use of an attenuation AR measured at each point P in the same cable section CS and an attenuation correction parameter ARP, a deviation value is calculated from the attenuation AR measured at the point P and the attenuation AR is thereby corrected. Furthermore, by performing statistical processing of attenuations AR measured at respective points P in the same cable section CS, the correction unit 15c calculates attenuation correction parameters ARP. On the basis of attenuations AR-P measured in the past, an attenuation correction parameter ARP is calculated by statistical processing, which may be any of: calculation of the standard deviation, variance, mean, variation coefficient, weighted average, intermediate value, and median, and other statistical methods (generation of a histogram). Furthermore, by performing statistical processing of attenuations AR-P measured in the past at respective points P in the same cable section CS, the correction unit 15c calculates attenuation correction parameters ARP. Furthermore, by statistical processing including at least average processing, the correction unit 15c calculates an attenuation correction parameter ARP. Furthermore, the correction unit 15c calculates an attenuation correction parameter ARP by one or more kinds of statistical processing selected from a group including: calculation of the mean; calculation of the variance; and calculation of the variation coefficient. Furthermore, the correction unit 15c numerically expresses influence by the heat radiation state or the installation state, for example, using an attenuation correction parameter ARP. Furthermore, by reflecting an attenuation correction parameter ARP in an attenuation AR that has been measured, the correction unit 15c calculates a corrected attenuation AR-DC. Furthermore, the correction unit 15c may calculate, for each point P in a cable section CS, a numerical value attributable to an amount of electric current by statistical processing, which may be any of calculation of the standard deviation, variance, mean, variation coefficient, weighted average, intermediate value, and median, and other statistical methods (generation of a histogram), reflect the numerical value attributable to the amount of electric current in a corrected attenuation AR-DC, and thereby calculate a corrected attenuation AR-DC.

The following description is on a specific example of the attenuation correction process. Firstly, for the cable C-2 identified by "C002", the correction unit 15c refers to section information I stored in the section information storage unit 14b, {Measurement point: "MP201", Cable section: "CS002-C"}, {Measurement point: "MP202", Cable section: "CS002-C}, and {Measurement point: "MP203", Cable section: "CS002-C"}. Secondly, for the cable C-2 identified by "C002", the correction unit 15c refers to attenuations AR of light stored in the measurement data storage unit 14a, {Measurement point: "MP201", Attenuation: "AR201}, {Measurement point: "MP202", Attenuation: "AR202"}, and {Measurement point: "MP203", Attenuation: "AR203"}, which correspond to the same cable section CS. Thirdly, the correction unit 15c calculates a mean value "ARA201-203", which is the mean of attenuations "AR201" to "AR203" measured at the measurement points "MP201" to "MP203". Fourthly, the correction unit 15c refers to, for the cable C-2 identified by "C002", attenuation correction parameters ARP stored in the correction data storage unit 14c, {Measurement point: "MP201", Attenuation correction parameter: "ARP201"}, {Measurement point: "MP202", Attenuation correction parameter: "ARP202"}, and {Measurement point: "MP203, Attenuation correction parameter: "ARP203"}. Fifthly, the correction unit 15c calculates a variation coefficient using the mean value "ARA201-203" for the attenuations "AR201" to "AR203" measured at the measurement points "MP201" to "MP203", finds a deviation value from each of the attenuation correction parameters "ARP201" to "ARP203", and thereby calculates corrected attenuations AR-DC, {Measurement point: "MP201", Corrected attenuation: "AR201-DC"}, {Measurement point: "MP202", Corrected attenuation: "AR202-DC"}, and {Measurement point: "MP203", Corrected attenuation: "AR203-DC"}. Sixthly, the correction unit 15c stores the corrected attenuations AR-DC calculated, into the correction data storage unit 14c.

### 2-2-5-4. Monitoring Unit 15d

The monitoring unit 15d executes various kinds of monitoring. The monitoring unit 15d may store a monitoring result D that the monitoring unit 15d has output, into the storage unit 14. Furthermore, the monitoring unit 15d may refer to various kinds of information stored in the storage unit 14. The following description is on an abnormality detection process (a temperature abnormality detection process and an attenuation abnormality detection process).

### Abnormality Detection Process

The monitoring unit 15d executes an abnormality detection process. For example, on the basis of measurement data M and section information I, the monitoring unit 15d monitors whether or not any abnormality in the cable C is present for each of plural cable sections CS. Furthermore, by using corrected measurement data M-DC, which are measurement data M that have been corrected, the monitoring unit 15d detects any abnormality in the cable C. In this process, in a case where the corrected measurement data M-DC exceed an upper limit threshold X, the monitoring unit 15d detects an abnormality in the cable C. Furthermore, in a case where the corrected measurement data M-DC are less than a lower limit threshold Y, the monitoring unit 15d detects an abnormality in the cable C.

### Temperature Abnormality Detection Process

The monitoring unit 15d executes the temperature abnormality detection process as the abnormality detection process. For example, on the basis of temperatures T and section information I, the monitoring unit 15d monitors whether or not any abnormality in the cable C is present for each of plural cable sections CS. Furthermore, by using corrected temperatures T-DC, which are temperatures T that have been corrected, the monitoring unit 15d detects any abnormality in the cable C. In this process, in a case where a corrected temperature T-DC exceeds an upper limit temperature threshold X_{T}, the monitoring unit 15d detects an abnormality in the cable C (for example, damage to the cable C). Furthermore, in a case where a corrected temperature T-DC is less than a lower limit temperature threshold Y_{T}, the monitoring unit 15d detects an abnormality in the cable C (for example, exposure of the cable C to the sea).

The following description is on a specific example of the temperature abnormality detection process. Firstly, for the cable C-1 identified by "C001", the monitoring unit 15d refers to section information I stored in the section information storage unit 14b, {Measurement point: "MP101 ", Cable section: "CS001-A"}, {Measurement point: "MP102", Cable section: "CS001-B"}, and {Measurement point: "MP103", Cable section: "CS001-B"}. Secondly, for the cable C-1 identified by "C001", the monitoring unit 15d refers to a corrected temperature T-DC stored in the correction data storage unit 14c, {Measurement point: "MP101", Corrected temperature: "T101-DC"} corresponding to the same cable section CS. Thirdly, the monitoring unit 15d determines, for example, that the corrected temperature "T101-DC" exceeds the upper limit temperature threshold X_{T} and detects that a temperature abnormality has occurred at the measurement point "MP101". Furthermore, the monitoring unit 15d determines, for example, that the corrected temperature "T101-DC" is less than the lower limit temperature threshold Y_{T}, and detects that a temperature abnormality has occurred at the measurement point "MP101". Fourthly, the monitoring unit 15d stores a monitoring result D, which is the detected temperature abnormality, {Measurement point: "MP101", Abnormality detection: "Yes", Abnormality level: "AD101"}, into the monitoring result storage unit 14d.

### Attenuation Abnormality Detection Process

The monitoring unit 15d executes the attenuation abnormality detection process as the abnormality detection process. For example, on the basis of attenuations AR of light and section information I, the monitoring unit 15d monitors whether or not any abnormality in the cable C is present for each of plural cable sections CS. Furthermore, by using corrected attenuations AR-DC, which are attenuations AR of light that have been corrected, the monitoring unit 15d detects any abnormality in the cable C. In this process, in a case where a corrected attenuation AR-DC exceeds the upper limit attenuation threshold X_{AR}, the monitoring unit 15d detects an abnormality in the cable C (for example, a stretch in the cable C). Furthermore, in a case where a corrected attenuation AR-DC is less than the lower limit attenuation threshold Y_{AR}, the monitoring unit 15d detects an abnormality in the cable C (for example, a bend or deterioration in the cable C).

The following description is on a specific example of the attenuation abnormality detection process. Firstly, for the cable C-2 identified by " C002", the monitoring unit 15d refers to section information I stored in the section information storage unit 14b, {measurement point: "MP201", Cable section: "CS002-C"}, {Measurement point: "MP202", Cable section: "CS002-C"}, and {Measurement point: "MP203", Cable section: "CS002-C"}. Secondly, for the cable C-2 identified by "C002", the monitoring unit 15d refers to corrected attenuations AR-DC stored in the correction data storage unit 14c, {Measurement point: "MP201 ", Corrected attenuation: "AR201-DC"}, {Measurement point: "MP202", Corrected attenuation: "AR202-DC"}, and {Measurement point: "MP203", Corrected attenuation: "AR203-DC"}, which correspond to the same cable section CS. Thirdly, the monitoring unit 15d determines, for example, that the corrected attenuation "AR202-DC" exceeds the upper limit attenuation threshold X_{AR}, and detects that an attenuation abnormality has occurred at the measurement point "MP202". Furthermore, the monitoring unit 15d determines, for example, that the corrected attenuation "AR202-DC" is less than the lower limit attenuation threshold Y_{AR}, and detects that an attenuation abnormality has occurred at the measurement point "MP202". Fourthly, the monitoring unit 15d stores a monitoring result D, which is the attenuation abnormality detected, {Measurement point: "MP202", Abnormality detection: "Yes", Abnormality level: "AD202"}, into the monitoring result storage unit 14d.

### 2-3. Example of Configuration of and Example of Processes in Measurement Apparatus 20

An example of a configuration of and an example of processes in a measurement apparatus 20 will be described by use of FIG. 2. For example, the measurement apparatus 20 is connected to an optical fiber F included in a cable C and measures measurement data M representing a characteristic of the optical fiber F in the cable C. Furthermore, the measurement apparatus 20 measures, as measurement data M, a temperature T at each point P on the optical fiber F in the cable C. Furthermore, the measurement apparatus 20 measures, as measurement data M, an attenuation AR of light at each point P on the optical fiber F in the cable C.

### 3. Specific Example of Each Process in Cable Monitoring System 100

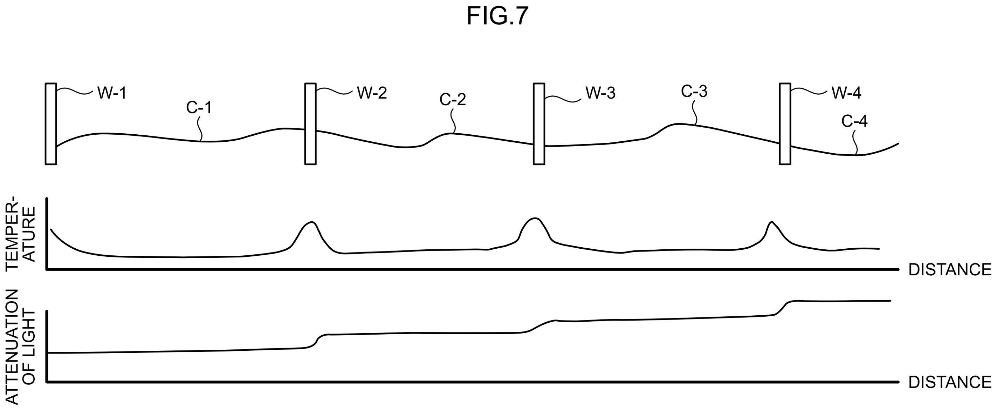

A specific example of each process in the cable monitoring system 100 according to the embodiment will be described by use of FIG. 7 to FIG. 11. The specific example of each process in the cable monitoring system 100 described hereinafter includes a specific example of a section setting process, a specific example of a data correction process, and a specific example of a cable monitoring process.

### 3-1. Specific Example of Section Setting Process

The specific example of the section setting process in the cable monitoring system 100 will be described by use of FIG. 7. FIG. 7 is a diagram illustrating the specific example of the section setting process in the cable monitoring system 100 according to the embodiment. A section setting process by temperature T of cables C and a section setting process by attenuation AR of light will hereinafter be described after a description of an example of a configuration of wind power generation facilities.

### 3-1-1. Example of Configuration of Wind Power Generation Facilities

As illustrated by the example in FIG. 7, the wind power generation facilities have plural wind turbines W and plural cables C connected to each other. In the example of FIG. 7, the plural wind turbines W are connected by the cables C in the order, a wind turbine W-1, a wind turbine W-2, a wind turbine W-3, and a wind turbine W-4 from an offshore point on the sea to an onshore point and transmit electricity A that the wind turbines W generate, to an electrical substation (not illustrated in the drawings) that is onshore. Furthermore, the plural cables C include a cable C-1 connecting the wind turbine W-1 and the wind turbine W-2, a cable C-2 connecting the wind turbine W-2 and the wind turbine W-3, a cable C-3 connecting the wind turbine W-3 and the wind turbine W-4, and a cable C-4 connecting the wind turbine W-4 and the electrical substation (not illustrated in the drawings). Furthermore, the cables C are buried underground beneath the seabed and are partly exposed to the sea from underground at positions where the wind turbines W are connected.

### 3-1-2. Section Setting Process by Temperature T of Cables C

The following description is on the section setting process by temperature T of the cables C. As illustrated by the example in FIG. 7, temperatures T of the cables C tend to be higher in regions around the wind turbines W due to influence of facilities of the wind turbines W. Furthermore, due to the amount of electric power increasing as the electricity A generated is transmitted from the offshore point on the sea to the onshore point, the temperatures T of the cables C tend to gradually increase in the order, the cable C-1, the cable C-2, the cable C-3, and the cable C-4. In the cable monitoring system 100, the operator terminal 10 is capable of collecting past temperatures T-P, determining characteristic differences in the cables C according to a trend in temperatures T, and setting cable sections CS each being where the characteristic of the cable C is common. Furthermore, in consideration of a trend in attenuations AR of light described later, the operator terminal 10 is capable of setting cable sections CS each being where the characteristic of the cable C is common. Furthermore, in the cable monitoring system 100, the operator O is able to determine characteristic differences in the cables C according to a trend in temperatures T and to input cable sections CS each being where the characteristic of the cable C is common.

### 3-1-3. Section Setting Process by Attenuation AR of Light

The following description is on the section setting process by attenuation AR of light through the cables C. As illustrated by the example in FIG. 7, as the distance increases from the onshore point to the offshore point on the sea, attenuations AR of light through the cables C tend to gradually decrease in the order, the cable C-4, the cable C-3, the cable C-2, and the cable C-1. In the cable monitoring system 100, the operator terminal 10 is capable of collecting past attenuations AR-P of light, determining characteristic differences in the cables C according to a trend in attenuations AR, and setting cable sections CS each being where the characteristic of the cable C is common. Furthermore, in consideration of also the trend in temperatures T mentioned above, the operator terminal 10 is capable of setting cable sections CS each being where the characteristic of the cable C is common. Furthermore, in the cable monitoring system 100, the operator O is able to determine characteristic differences in the cables C according to a trend in attenuations AR of light and to input cable sections CS each being where the characteristic of the cable C is common.

### 3-2. Specific Example of Data Correction Process

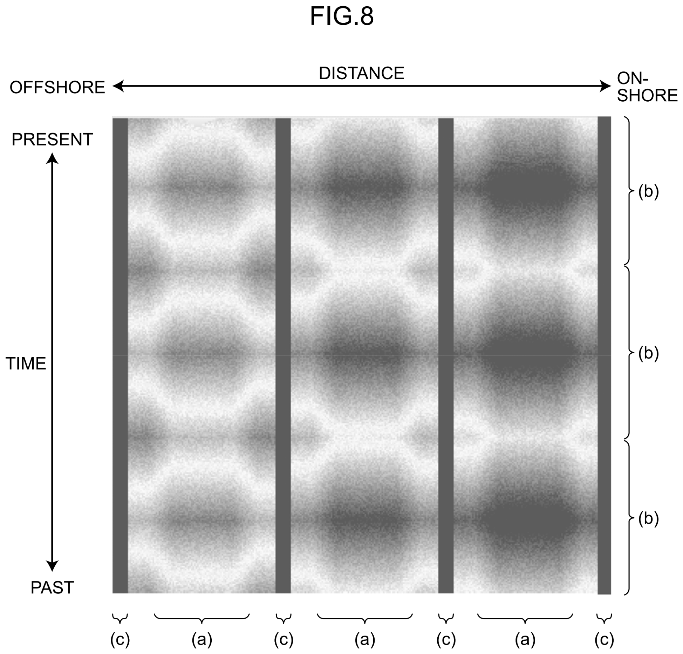

The specific example of the data correction process in the cable monitoring system 100 will be described by use of FIG. 8 to FIG. 10. First to third specific examples of the data correction process will be described hereinafter after a description of data correction principles.

### 3-2-1. Data Correction Principles

The following description is on data correction principles in the cable monitoring system 100. Calculation principles for correction parameters CP and calculation principles for corrected measurement data M-DC will be described hereinafter.

### 3-2-1-1. Calculation Principles for Correction Parameters CP

The following description is on calculation principles for correction parameters CP in the cable monitoring system 100. The calculation principles for correction parameters CP and corrected measurement data M-DC will be described hereinafter, the correction parameters CP being corrected values of measurement data M on the cables C at the respective points P.

### Correction Parameters CP

In the cable monitoring system 100, on the basis of past measurement data M-P for the respective points P, variability of the past measurement data M-P is each normalized by use of a variation coefficient corresponding to one type of statistical processing. Furthermore, in the cable monitoring system 100, on the basis of a numerical value resulting from the normalization by use of the variation coefficient, a correction parameter CP for each point P is calculated and recorded. Furthermore, in the cable monitoring system 100, present measurement data M for each point P are normalized and reflected in the correction parameter CP as appropriate.

### Corrected Measurement Data M-DC

In the cable monitoring system 100, finding a deviation value for measurement data M at each point P on the basis of a correction parameter CP enables corrected measurement data M-DC to be calculated and recorded for each point P.

### 3-2-2. First Specific Example of Data Correction Process

The first specific example of the data correction process in the cable monitoring system 100 will be described by use of FIG. 8. FIG. 8 is a diagram illustrating the first specific example of the data correction process in the cable monitoring system 100 according to the embodiment. A distribution of measurement data M representing a relation between distance and time prior to execution of the data correction process will be described hereinafter, the distribution being an actual temperature distribution of temperatures T.

FIG. 8 is a graph representing a distribution of temperatures T of the cables C connected to the four wind turbines W, the wind turbines W-1 to W-4. The vertical axis in FIG. 8 represents time based on times and dates of measurement of the temperatures T, with newer data appearing toward the top and older data toward the bottom. Furthermore, the horizontal axis in FIG. 8 represents distance d of points P from a predetermined position, the points P being where the temperatures T of the cables C were measured, with more onshore data appearing toward the right and more offshore data appearing toward the left. In FIG. 8, darker and lighter areas are areas high in temperature T or areas low in temperature T.

Areas (a) in FIG. 8 correspond to noise resulting from characteristic differences depending on the points P, that is, environmental influence, such as geological features, and measured temperatures T in areas corresponding to buried positions in the seabed are higher than those in the other areas. Furthermore, areas (b) in FIG. 8 correspond to noise resulting from temporal characteristic differences, such as different amounts of power generated, that is, changes in the amount of power generated, measured temperatures T in central areas are higher than those in the other areas, and measured temperatures T in peripheral areas are lower than those in the other areas. Furthermore, areas (c) in FIG. 8 are areas corresponding to positions where the wind turbines W1 to W4 are installed and the temperature therein is constant.

### 3-2-3. Second Specific Example of Data Correction Process

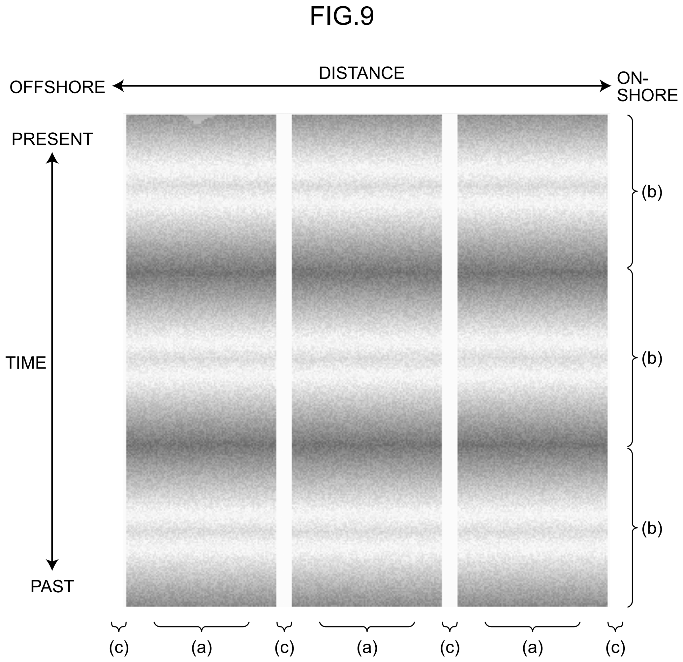

The second specific example of the data correction process in the cable monitoring system 100 will be described by use of FIG. 9. FIG. 9 is a diagram illustrating the second specific example of the data correction process in the cable monitoring system 100 according to the embodiment.

FIG. 9 is a graph representing a distribution of corrected temperatures T-DC₁ of the cables C connected to the four wind turbines W, the wind turbines W-1 to W-4, and is a graph after execution of regional correction that removes noise resulting from characteristic differences depending on the points P. The vertical axis in FIG. 9 represents the time based on the times and dates of the measurement of the temperatures T, with newer data appearing toward the top and older data toward the bottom. Furthermore, the horizontal axis in FIG. 9 represents the distance d of the points P from the predetermined position, the points P being where the temperatures T of the cables C were measured, with more onshore data appearing toward the right and more offshore data appearing toward the left. In FIG. 9, darker and lighter areas are areas high in temperature T or areas low in temperature T.

In FIG. 9, the noise resulting from the characteristic differences depending on the points P illustrated by the areas (a) in FIG. 8 has been removed and a data correction process for the points P has been executed.

### 3-2-4. Third Specific Example of Data Correction Process

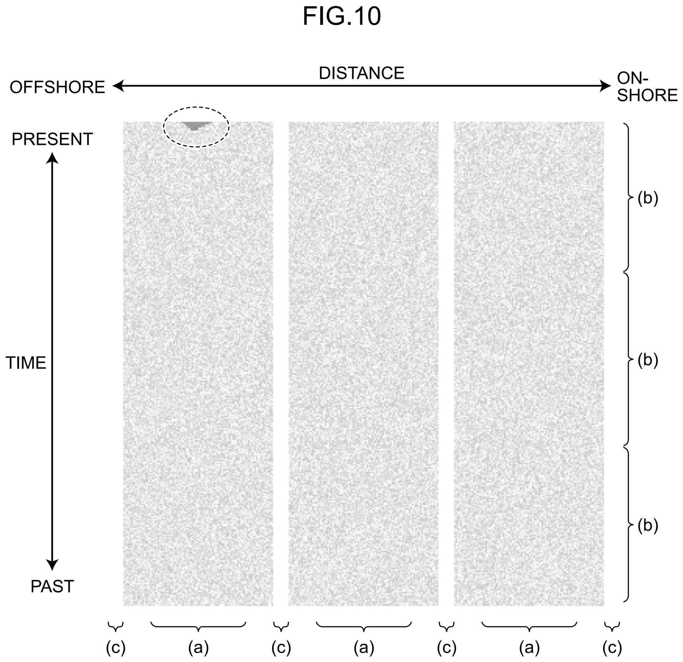

The third specific example of the data correction process in the cable monitoring system 100 will be described by use of FIG. 10. FIG. 10 is a diagram illustrating the third specific example of the data correction process in the cable monitoring system 100 according to the embodiment.

FIG. 10 is a graph representing a distribution of corrected temperatures T-DC₂ of the cables C connected to the four wind turbines W, the wind turbines W-1 to W-4, and is a graph after execution of regional correction that removes the noise resulting from the characteristic differences depending on the points P and execution of temporal correction that removes the noise resulting from the temporal characteristic differences. The vertical axis in FIG. 10 represents the time based on the times and dates of the measurement of the temperatures T, with newer data appearing toward the top and older data toward the bottom. Furthermore, the horizontal axis in FIG. 10 represents the distance d of the points P from the predetermined position, the points P being where the temperatures T of the cables C were measured, with more onshore data appearing toward the right and more offshore data appearing toward the left. In FIG. 10, darker and lighter areas are regions high in temperature T or areas low in temperature T.

In FIG. 10, the noise resulting from the characteristic differences depending on the points P illustrated by the areas (a) in FIG. 8 and the noise resulting from the temporal characteristic differences illustrated by the areas (b) in FIG. 8 have been removed and a data correction process for the points P has been executed. As illustrated by a dashed ellipse in FIG. 10, the operator terminal 10 reduces the noise by executing the data correction process and enables more precise detection of a temperature abnormality due to damage to a cable C, for example.

### 3-3. Specific Example of Cable Monitoring Process

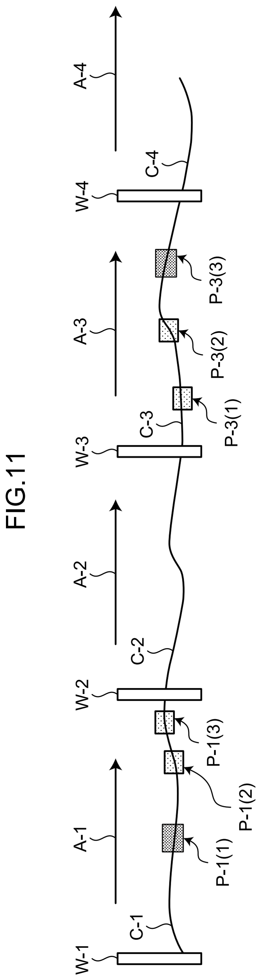

The specific example of the cable monitoring process in the cable monitoring system 100 will be described by use of FIG. 11. FIG. 11 is a diagram illustrating the specific example of the cable monitoring process in the cable monitoring system 100 according to the embodiment. A cable monitoring process using temperatures T of the cables C will be described hereinafter after a description of an example of a configuration of wind power generation facilities.

### 3-3-1. Example of Configuration of Wind Power Generation Facilities

As illustrated by the example in FIG. 11, the wind power generation facilities have plural wind turbines W and plural cables C connected to each other. In the example of FIG. 11, the plural wind turbines W are connected by the cables C in the order, a wind turbine W-1, a wind turbine W-2, a wind turbine W-3, and a wind turbine W-4, from an offshore point on the sea to an onshore point and transmit electricity A that the wind turbines W generate, to an electrical substation (not illustrated in the drawings) that is onshore. Furthermore, the plural cables C include a cable C-1 connecting the wind turbine W-1 and the wind turbine W-2, a cable C-2 connecting the wind turbine W-2 and the wind turbine W-3, a cable C-3 connecting the wind turbine W-3 and the wind turbine W-4, and a cable C-4 connecting the wind turbine W-4 and the electrical substation (not illustrated in the drawings).

Electricity A-1 flowing through the cable C-1 transmits electricity A generated by the wind turbine W-1 to the wind turbine W-2. Furthermore, electricity A-2 flowing through the cable C-2 transmits electricity A generated by the wind turbine W-1 and the wind turbine W-2 to the wind turbine W-3. Furthermore, electricity A-3 flowing through the cable C-3 transmits electricity A generated by the wind turbine W-1, the wind turbine W-2, and the wind turbine W-3, to the wind turbine W-4. Furthermore, electricity A-4 flowing through the cable C-4 transmits electricity A generated by the wind turbine W-1, the wind turbine W-2, the wind turbine W-3, and the wind turbine W-4, to the electrical substation (not illustrated in the drawings).

### 3-3-2. Cable Monitoring Process Using Temperatures T of Cables C

The following description is on a cable monitoring process using measurement data M on the cables C, the cable monitoring process being a cable monitoring process using temperatures T. The example in FIG. 11 illustrates abnormality detection for the cables C using cable sections CS each set correspondingly to a location where the amount of electric current in the cable C is common. In the example of FIG. 11, the operator terminal 10 acquires, for the cable C-1 that is the same cable section CS, a temperature T at each of a point P-1(1), a point P-1(2), and a point P-1(3). For the same cable section CS, because the point P-1(1) is high in temperature and the point P-1(2) and the point P-1(3) are at temperatures T that are normal, the operator terminal 10 detects that there is heat generation at the point P-1(1), the heat generation resulting from resistance due to damage, the resistance being other than cable resistance, and determines that the point P-1(1) has been damaged. Similarly, for the cable C-3 that is the same cable section CS, the operator terminal 10 acquires a temperature T at each of a point P-3(1), a point P-3(2), and a point P-3(3). For the same cable section CS, because the point P-3(3) is high in temperature and the point P-3(1) and the point P-3(2) are at temperatures T that are normal, the operator terminal 10 detects that there is heat generation at the point P-3(3), the heat generation resulting from resistance due to damage, the resistance being other than cable resistance, and determines that the point P-3(3) has been damaged.

### 3-3-3. Others

In the above described example of FIG. 11, the cable sections CS each set correspondingly to a location where the electricity A, that is, the amount of electric current flowing through the cable C is common are used, but cable sections CS may be set over plural locations of the same cable C or set over plural cables C. For example, in the example of FIG. 11, the operator terminal 10 may set a cable section CS at the point P-1(1) as "Cable Section 1" and a cable section CS at the P-1(2) and the point P-1(3) as "Cable Section 2" because geological features of soil where the cable C-1 is buried vary. Furthermore, in the example of FIG. 11, the operator terminal 10 may set a cable section CS at the point P-1(3) and the point P-3(1) as "Cable Section 3" because the cables C there are exposed to the sea due to their connections with the wind turbines W at the point P-1(3) and the point P-3(1).

### 4. Flow of Each Process in Cable Monitoring System 100

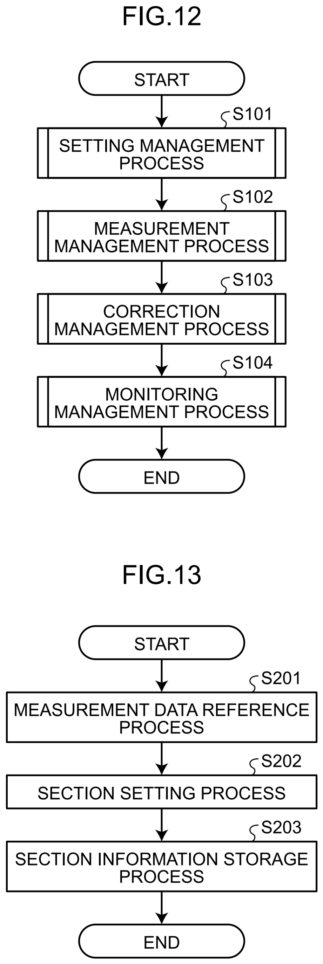

Flows of processes in the cable monitoring system 100 according to the embodiment will be described by use of FIG. 12 to FIG. 16. A measurement management process, a setting management process, a correction management process, and a monitoring management process will be described as the processes hereinafter, after a description of a flow of an overall process in the cable monitoring system 100.

### 4-1. Overall Process in Cable Monitoring System 100

The flow of the overall process in the cable monitoring system 100 according to the embodiment will be described by use of FIG. 12. FIG. 12 is a flowchart illustrating an example of an overall flow in the cable monitoring system 100 according to the embodiment. Processes at Steps S101 to S104 described below may be executed in a different order. Furthermore, some of the processes at Steps S101 to S104 described below may be omitted.

### 4-1-1. Setting Management Process

Firstly, the cable monitoring system 100 executes the setting management process (Step S101). For example, by executing processes at Steps S201 to S203 described later, the cable monitoring system 100 manages section information I including cable sections CS each set correspondingly to a location where a characteristic of the cable C is common.

### 4-1-2. Measurement Management Process

Secondly, the cable monitoring system 100 executes the measurement management process (Step S102). For example, the cable monitoring system 100 manages measurement data M representing characteristics of the cables C by executing processes at Steps S301 to S304 described later.

### 4-1-3. Correction Management Process

Thirdly, the cable monitoring system 100 executes the correction management process (Step S103). For example, the cable monitoring system 100 manages corrected measurement data M resulting from correction of the measurement data M, by executing processes at Steps S401 to S404 described later.

### 4-1-4. Monitoring Management Process

Fourthly, the cable monitoring system 100 executes the monitoring management process (Step S104) and ends the process. For example, the cable monitoring system 100 manages monitoring results D indicating whether or not any abnormality is present in the cables C by executing processes at Steps S501 to S503 described later.

### 4-2. Setting Management Process

A flow of the setting management process in the cable monitoring system 100 according to the embodiment will be described by use of FIG. 13. FIG. 13 is a flowchart illustrating an example of the flow of the setting management process in the cable monitoring system 100 according to the embodiment. The processes at Steps S201 to S203 described below may be executed in a different order. Furthermore, some of the processes at Steps S201 to S203 described below may be omitted.

### 4-2-1. Measurement Data Reference Process

Firstly, the operator terminal 10 executes a measurement data reference process (Step S201). For example, the operator terminal 10 refers to past measurement data M-P measured by the measurement apparatuses 20 for the cables C. The past measurement data M-P are temperatures T-P or attenuations AR-P of light stored in the measurement data storage unit 14a.

### 4-2-2. Section Setting Process

Secondly, the operator terminal 10 executes the section setting process (Step S202). For example, by using the past measurement data M-P, which are the temperatures T-P or the attenuations AR-P of light, the operator terminal 10 sets plural cable sections CS, each being where the characteristic of the cable C is common.

### 4-2-3. Section Information Storage Process

Thirdly, the operator terminal 10 executes a section information storage process (Step S203) and ends the setting management process. For example, the operator terminal 10 stores, as section information I, the plural cable sections CS that have been set, into the section information storage unit 14b.

### 4-3. Measurement Management Process

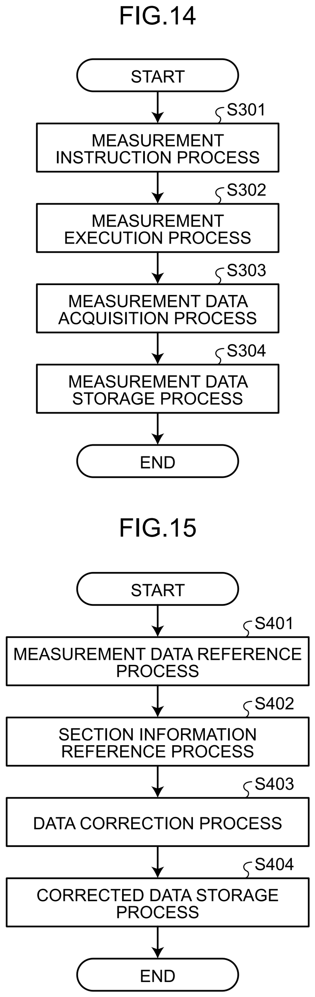

A flow of the measurement management process in the cable monitoring system 100 according to the embodiment will be described by use of FIG. 14. FIG. 14 is a flowchart illustrating an example of the flow of the measurement management process in the cable monitoring system 100 according to the embodiment. Processes at Steps S301 to S304 described below may be executed in a different order. Furthermore, some of the processes at Step S301 to S304 described below may be omitted.

### 4-3-1. Measurement Instruction Process

Firstly, the operator terminal 10 executes a measurement instruction process (Step S301). For example, the operator terminal 10 causes the measurement apparatuses 20 to execute measurement of measurement data M on the cables C by transmitting control signals to the measurement apparatuses 20.

### 4-3-2. Measurement Execution Process

Secondly, the measurement apparatuses 20 execute a measurement execution process (Step S302). For example, the measurement apparatuses 20 measure, as measurement data M, temperatures T of or attenuations AR of light through the optical fibers F connected thereto.

### 4-3-3. Measurement Data Acquisition Process

Thirdly, the operator terminal 10 executes a measurement data acquisition process (Step S303). For example, the operator terminal 10 acquires present measurement data M or past measurement data M-P measured by the measurement apparatuses 20 (20-1, 20-2, 20-3, ...).

### 4-3-4. Measurement Data Storage Process

Fourthly, the operator terminal 10 executes a measurement data storage process (Step S304) and ends the measurement management process. For example, the operator terminal 10 stores the present measurement data M or past measurement data M-P acquired, into the measurement data storage unit 14a.

### 4-4. Correction Management Process

A flow of the correction management process in the cable monitoring system 100 according to the embodiment will be described by use of FIG. 15. FIG. 15 is a flowchart illustrating an example of the flow of the correction management process in the cable monitoring system 100 according to the embodiment. Processes at Step S401 to S404 described below may be executed in a different order. Furthermore, some of the processes at Step S401 to S404 described below may be omitted.

### 4-4-1. Measurement Data Reference Process

Firstly, the operator terminal 10 executes the measurement data reference process (Step S401). For example, the operator terminal 10 refers to temperatures T or attenuations AR of light, which have been stored in the measurement data storage unit 14a.

### 4-4-2. Section Information Reference Process

Secondly, the operator terminal 10 executes a section information reference process (Step S402). For example, the operator terminal 10 refers to section information I stored in the section information storage unit 14b.

### 4-4-3. Data Correction Process

Thirdly, the operator terminal 10 executes the data correction process (Step S403). For example, the operator terminal 10 corrects measurement data M for each cable section CS indicated by the section information I and calculates corrected measurement data M-DC.

### 4-4-4. Corrected Data Storage Process

Fourthly, the operator terminal 10 executes a corrected data storage process (Step S404) and ends the correction management process. For example, the operator terminal 10 stores the corrected measurement data M-DC calculated, into the correction data storage unit 14c.

### 4-5. Monitoring Management Process

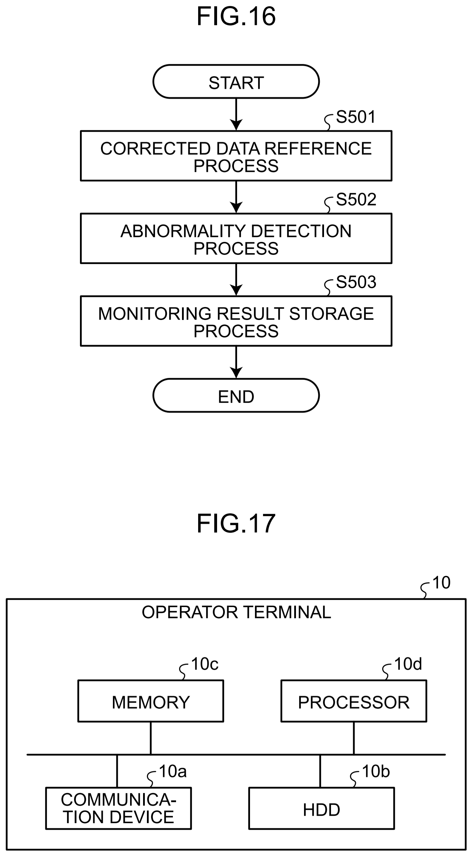

A flow of the monitoring management process in the cable monitoring system 100 according to the embodiment will be described by use of FIG. 16. FIG. 16 is a flowchart illustrating an example of the flow of the monitoring management process in the cable monitoring system 100 according to the embodiment. Processes at Steps S501 to S503 described below may be executed in a different order. Furthermore, some of the processes at Step S501 to S503 described below may be omitted.

### 4-5-1. Corrected Data Reference Process

Firstly, the operator terminal 10 executes a corrected data reference process (Step S501). For example, the operator terminal 10 refers to the corrected measurement data M-DC stored in the correction data storage unit 14c.

### 4-5-2. Abnormality Detection Process

Secondly, the operator terminal 10 executes the abnormality detection process (Step S502). For example, in a case where the corrected measurement data M-DC exceed the upper limit threshold X or in a case where the corrected measurement data M-DC are less than the lower limit threshold Y, the operator terminal 10 detects an abnormality in the cable C.

### 4-5-3. Monitoring Result Storage Process

Thirdly, the operator terminal 10 executes a monitoring result storage process (Step S503) and ends the monitoring management process. For example, the operator terminal 10 stores a monitoring result D indicating whether or not a detected abnormality is present, into the monitoring result storage unit 14d.

### 5. Effects of Embodiment

The following description is on effects of the embodiment. First to fourteenth effects corresponding to the processes according to the embodiment will be described hereinafter.

### 5-1. First Effect

Firstly, in a process according to the embodiment, the operator terminal 10: stores section information I indicating plural cable sections CS each being a section where a state of a cable C is common, the cable C connecting plural facilities and including a power transmission line L and an optical fiber F; acquires measurement data M representing a characteristic of the optical fiber F in the cable C; and monitors the cable C for each of the plural cable sections CS on the basis of the measurement data M and the section information I. Therefore, this process enables improvement in precision of monitoring of the cable C.

### 5-2. Second Effect

Secondly, in a process according to the embodiment, the operator terminal 10 corrects the measurement data M for each of the plural cable sections CS, and detects an abnormality in the cable C by using the measurement data M that have been corrected. Therefore, correcting the measurement data M on the cable C for each of the plural cable sections CS in this process enables improvement in precision of monitoring of the cable C.

### 5-3. Third Effect

Thirdly, in a process according to the embodiment, the operator terminal 10 corrects the measurement data M by using a correction parameter CP for each point P in the same cable section CS. Therefore, correcting the measurement data M on the cable C for each of the plural cable sections CS by using the correction parameter CP in this process enables improvement in precision of monitoring of the cable C.

### 5-4. Fourth Effect

Fourthly, in a process according to the embodiment, the operator terminal 10 corrects the measurement data M by calculating, using the measurement data M measured at each point P in the same cable section CS and the correction parameter CP, a deviation value from the measurement data M measured at each point P. Therefore, correcting the measurement data M on the cable C for each of the plural cable sections CS in consideration of influence of the heat radiation, installation, season, or transmitted electric current in this process enables improvement in precision of monitoring of the cable C.

### 5-5. Fifth Effect

Fifthly, in a process according to the embodiment, the operator terminal 10 calculates the correction parameter CP by statistical processing of the measurement data M measured at each point P in the same cable section CS. Therefore, calculating the correction parameters CP in consideration of the influence of the heat radiation, installation, or season and correcting the measurement data M on the cable C in this process enables improvement in precision of monitoring of the cable C.

### 5-6. Sixth Effect

Sixthly, in a process according to the embodiment, the operator terminal 10 calculates the correction parameters CP by statistical processing of measurement data M-P measured in the past at each point in the same cable section CS. Therefore, calculating the correction parameter CP in consideration of a change in the influence of the electric current transmitted, for example, and correcting the measurement data M on the cable C in this process enables improvement in precision of monitoring of the cable C.

### 5-7. Seventh Effect

Seventhly, in a process according to the embodiment, the operator terminal 10 calculates the correction parameters CP by statistical processing including at least average processing. Therefore, correcting the measurement data M on the cable C by using the statistical processing including the average processing in this process enables improvement in precision of monitoring of the cable C.

### 5-8. Eighth Effect

Eighthly, in a process according to the embodiment, the operator terminal 10 stores: section information I set for each location including each point P on two or more cables C, each point P being a point where a characteristic of the optical fiber F is within a predetermined range; section information I set for each of plural locations each including each point P on one cable C, each point P being a point where a characteristic of the optical fiber F is within a predetermined range; or section information I set for each location including each point P in a region around a facility that two or more cables C are connected to and in a region other than the region around the facility. Therefore, setting the plural cable sections CS respectively for various locations in this process enables improvement in precision of monitoring of the cable C or cables C.

### 5-9. Ninth Effect

Ninthly, in a process according to the embodiment, the operator terminal 10 sets the plural cable sections CS each being a section where a state of the cable C is common, the state being the amount of electric current flowing through the power transmission line L, the heat radiation state of the cable C, or the installation state of the cable C. Therefore, automatically setting the cable sections CS each being where the amount of electric current through, the heat radiation state of, or the installation state of the cable C is common in this process enables improvement in precision of monitoring of the cable C.

### 5-10. Tenth Effect

Tenthly, in a process according to the embodiment, the operator terminal 10 sets the plural cable sections CS on the basis of the measurement data M-P measured in the past and stores the plural cable sections CS as the section information I, into the section information storage unit 14b. Therefore, automatically setting the plural cable sections CS from the past measurement data M-P in this process enables improvement in precision of monitoring of the cable C.

### 5-11. Eleventh Effect

Eleventhly, in a process according to the embodiment, the operator terminal 10 stores the section information I input by an operator O into the section information storage unit 14b. Therefore, manually setting the plural cable sections CS on the basis of the operator O's rule of thumb in this process enables improvement in precision of monitoring of the cable C.

### 5-12. Twelfth Effect

Twelfthly, in a process according to the embodiment, the measurement data M are temperatures T of the optical fiber F. Therefore, this process enables improvement in precision of monitoring of the cable C utilizing the temperatures T of the optical fiber F as the measurement data M.

### 5-13. Thirteenth Effect

Thirteenthly, in a process according to the embodiment, the measurement data M are attenuations AR of light through the optical fiber F. Therefore, this process enables improvement in precision of monitoring of the cable C utilizing the attenuations AR of light through the optical fiber F as the measurement data M.

### 5-14. Fourteenth Effect

Fourteenthly, in a process according to the embodiment, the plural facilities are plural power transmission facilities. Therefore, this process enables improvement in precision of monitoring of the cable C connecting the power transmission facilities.

### 6. Application Examples of Embodiment

The following description is on application examples of the embodiment. First to seventh application examples of the embodiment will be described hereinafter.

### 6-1. First Application Example

In the first application example of the embodiment, facilities connected by a cable C may be power transmission facilities between islands, power transmission facilities from an island to an offshore platform, and power transmission facilities from a large offshore platform to a small offshore platform.

### 6-2. Second Application Example

In the second application example of the embodiment, facilities connected by a cable C may be power generation facilities, such as tidal power generation facilities, solar power generation facilities, and hydroelectric power generation facilities, which are installed on oceans, lakes, and rivers.

### 6-3. Third Application Example

In the third application example of the embodiment, facilities connected by a cable C may be power generation facilities, such as wind power generation facilities, tidal power generation facilities, solar power generation facilities, hydroelectric power generation facilities, geothermal power generation facilities, and thermal power generation facilities, which are installed onshore.

### 6-4. Fourth Application Example

In the fourth application example of the embodiment, the measurement apparatuses 20 may execute any of various processes executed by the operator terminal 10.

### 6-5. Fifth Application Example

In the fifth application example of the embodiment, the operator terminal 10 may execute abnormality detection for the cable monitoring process by adopting any of calculation of the standard deviation, variance, mean, variation coefficient, weighted average, intermediate value, and median, and other statistical methods (generation of a histogram), as the statistical processing.

### 6-6. Sixth Application Example

In the sixth application example of this embodiment, the operator terminal 10 may execute, as the cable monitoring process, abnormality detection on the basis of prediction using an approximate curve (for example, a regression curve) or machine learning.

### 6.7. Seventh Application Example

In the seventh application example of the embodiment, the operator terminal 10 may execute, as the cable monitoring process, abnormality detection in not only a cable C including both an optical fiber F and a power transmission line L like a multi-core cable, but also in a state where an optical fiber F and a power transmission line L are nearby.

### 7. System

The process sequences, control sequences, specific names, and information including various data and parameters, which have been described above and illustrated in the drawings may be optionally modified unless particularly stated otherwise.

Furthermore, the components of each apparatus in the drawings have been illustrated functionally and/or conceptually, and do not need to be physically configured as illustrated in the drawings. That is, specific modes of distribution and integration of each apparatus are not limited to those illustrated in the drawings. That is, all or part of each apparatus may be configured to be functionally or physically distributed or integrated in any units according to various loads and use situations.

Furthermore, all or any part of the processing functions executed in each apparatus may be implemented by a CPU and a program analyzed and executed by the CPU, or may be implemented as hardware by wired logic.

### 8. Hardware

An example of a hardware configuration of the operator terminal 10 will be described next. The other apparatuses may have a similar hardware configuration. FIG. 17 is a diagram illustrating an example of a hardware configuration according to the embodiment. As illustrated in FIG. 17, the operator terminal 10 has a communication device 10a, a hard disk drive (HDD) 10b, a memory 10c, and a processor 10d. Furthermore, these units illustrated in FIG. 17 are connected to one another via a bus, for example.

The communication device 10a is a network interface card, for example, and performs communication with another server. The HDD 10b stores a program and a database that cause the functions illustrated in FIG. 2 to operate.

The processor 10d causes a process to be operated, the process executing the functions described by reference to FIG. 2, for example, by reading, from the HDD 10b, the program that executes the same processing as the processing units illustrated in FIG. 2, and loading the program into the memory 10c. For example, this process executes the same functions as the processing units that the operator terminal 10 has. Specifically, the processor 10d reads a program having functions similar to those of the acquisition unit 15a, the setting unit 15b, the correction unit 15c, and the monitoring unit 15d, from the HDD 10b, for example. The processor 10d then executes a process that executes processing similar to that by the acquisition unit 15a, the setting unit 15b, the correction unit 15c, and the monitoring unit 15d, for example.

As described above, by reading and executing the program according to the embodiment, the operator terminal 10 operates as an apparatus that executes various processing methods. Furthermore, the operator terminal 10 may implement functions similar to those according to the above described embodiment by reading the program from a recording medium by means of a medium reading device, and executing the program read. The program according to the embodiment is not limited to being executed by the operator terminal 10. For example, the present disclosure may be similarly applied to a case where another computer or server executes the program, or a case where the computer and the server execute the program in corporation with each other.

The program according to the embodiment may be distributed via a network, such as the Internet. Furthermore, the program may be executed by being recorded in a computer-readable recording medium, such as a hard disk, a flexible disk (FD), a CD-ROM, a magneto-optical disk (MO), or a digital versatile disc (DVD), and being read from the recording medium by a computer.

An effect achieved by the present disclosure is that precision of monitoring of a cable is able to be improved.

## Claims

1. A monitoring apparatus (10) comprising:
a storage unit (14); and
a processor connected to the storage unit (14), wherein
the storage unit (14) stores section information indicating plural sections each being a section where a state of a cable (C) is common, the cable (C) connecting plural facilities and including a power transmission line and an optical fiber, and
the processor executes:
acquiring measurement data representing a characteristic of the optical fiber in the cable (C); and
monitoring the cable (C) for each of the plural sections on the basis of the measurement data and the section information.

2. The monitoring apparatus (10) according to claim 1, wherein the processor executes:
correcting the measurement data for each of the plural sections; and
detecting an abnormality in the cable (C) by using the measurement data that have been corrected.

3. The monitoring apparatus (10) according to claim 2, wherein the processor executes correcting the measurement data by using a correction parameter for each point in the same section.

4. The monitoring apparatus (10) according to claim 3, wherein the processor executes correcting the measurement data by calculating, using the measurement data measured at each point in the same section and the correction parameter, a deviation value from the measurement data measured at the each point.

5. The monitoring apparatus (10) according to claim 4, wherein the processor executes calculating the correction parameter by statistical processing of the measurement data measured at the each point in the same section.

6. The monitoring apparatus (10) according to claim 5, wherein the processor executes calculating the correction parameter by statistical processing of the measurement data measured in the past at the each point in the same section.

7. The monitoring apparatus (10) according to claim 5 or 6, wherein the processor executes calculating the correction parameter by statistical processing including at least average processing.

8. The monitoring apparatus (10) according to any one of claims 1 to 7, wherein the storage unit (14) stores: the section information set for each location including each point on two or more of the cables (C), the each point being a point where the characteristic is within a predetermined range; the section information set for each of plural locations each including each point on the one cable (C), the each point being a point where the characteristic is within a predetermined range; or the section information set for each location including each point in a region around a facility that two or more of the cables (C) are connected to and in a region other than the region around the facility.

9. The monitoring apparatus (10) according to any one of claims 1 to 8, wherein the processor executes setting the plural sections each being a section where the state is common, the state being an amount of electric current flowing through the power transmission line, a heat radiation state of the cable (C), or an installation state of the cable (C).

10. The monitoring apparatus (10) according to claim 9, wherein the processor executes setting the plural sections on the basis of the measurement data measured in the past and storing the plural sections as the section information, into the storage unit (14).

11. The monitoring apparatus (10) according to claim 9 or 10, wherein the processor executes storing the section information input by a user, into the storage unit (14).

12. The monitoring apparatus (10) according to any one of claims 1 to 11, wherein the measurement data are temperatures of the optical fiber.

13. The monitoring apparatus (10) according to any one of claims 1 to 12, wherein the measurement data are attenuations of light through the optical fiber.

14. The monitoring apparatus (10) according to any one of claims 1 to 13, wherein the plural facilities are plural power transmission facilities.

15. A monitoring method, wherein a monitoring apparatus (10) executes:
acquiring measurement data representing a characteristic of an optical fiber in a cable (C) connecting plural facilities, the cable (C) including a power transmission line and the optical fiber; and
monitoring, on the basis of the measurement data and section information indicating plural sections each being a section where a state of the cable (C) is common, whether or not an abnormality in the cable (C) is present for each of the plural sections.

16. A monitoring program that causes a monitoring apparatus (10) to execute:
acquiring measurement data representing a characteristic of an optical fiber in a cable (C) connecting plural facilities, the cable (C) including a power transmission line and the optical fiber; and
monitoring, on the basis of the measurement data and section information indicating plural sections each being a section where a state of the cable (C) is common, whether or not an abnormality in the cable (C) is present for each of the plural sections.
